# FASCICULE DE BREVET EUROPEEN

(11) **EP 1 585 635 B1**
(45) Date de publication et mention de la délivrance du brevet: **25.02.2015**
(21) Numéro de dépôt: 04700702.6
(22) Date de dépôt: 08.01.2004
(51) Int. Cl.: B32B 17/10, C03C 17/23, B60Q 3/02, H01Q 1/12

(54) **VITRAGE COMPORTANT DES COMPOSANTS ELECTRONIQUES**
VERGLASUNG MIT EINEM LEUCHTELEMENT
GLAZING COMPRISING A LUMINOUS ELEMENT

(30) Priorité: 10.01.2003 BE 200300023; 28.11.2003 EP 03104456
(43) Date de publication de la demande: 19.10.2005
(73) Titulaire: AGC Glass Europe, 1348 Louvain-la-Neuve (BE)
(72) Inventeur: LEFEVRE, Hugues, GLAVERBEL - Centre R & D, B-6040 Jumet (BE)
(74) Mandataire: Bayot, Daisy
(86) Numéro de dépôt international: PCT/EP2004/050007
(87) Numéro de publication internationale: WO 2004/062908

(56) Documents cités:
- EP-A- 0 177 420
- EP-A- 0 608 180
- EP-A- 0 900 971
- EP-A- 1 071 142
- EP-A- 1 346 822
- EP-A1- 1 437 215
- EP-A1- 1 535 885
- WO-A-01/82378
- WO-A-03/024649
- WO-A-2004/009349
- DE-U- 29 716 214
- GB-A- 1 401 497
- US-A- 4 100 398
- US-A- 5 155 338
- US-A- 5 367 441
- US-A- 6 153 982
- US-B1- 6 270 236
- "Leuchtende Bilder in Glasscheiben" HTTP:, [Online] 25 octobre 2002 (2002-10-25), XP002241074 Extrait de l'Internet: URL:www.schott.com/architecture/english/ne ws/press.html> [extrait le 2003-05-13]
- PATENT ABSTRACTS OF JAPAN vol. 1995, no. 06, 31 juillet 1995 (1995-07-31) & JP 7 076131 A (KYOCERA CORP), 20 mars 1995 (1995-03-20)

## Description

La présente invention concerne des vitrages, en particulier en verre feuilleté, dans lesquels des composants électroniques ont été insérés.

La surface de vitrage est de plus en plus importante dans les véhicules et les bâtiments. De plus, cette surface est particulièrement mise en évidence par rapport à l'extérieur du véhicule ou du bâtiment, au regard de ses occupants, ce qui permet de prévoir des fonctions totalement nouvelles pour ces vitrages. Par vitrage automobile, on entend les pare-brise, lunettes arrières, vitres latérales mais aussi les toits ouvrants ou non ouvrants, les rétroviseurs, ou verre de protection des phares.

L'invention consiste à insérer des composants électroniques, ainsi que leur circuit de connexion, à l'intérieur d'un verre feuilleté afin de conférer à celui-ci des fonctionnalités nouvelles telles que capteurs, éclairages, voyant de signalisation, ....

Parmi les composants électroniques intéressants à insérer, les composants optoélectroniques tels que notamment les diodes électroluminescentes (LED), les photo résistances, les photodiodes et les capteurs de vision, par exemple du type CCD (Charge coupled device) et CMOS (Complementary Metal Oxide Semi conductor) sont particulièrement utiles car directement en rapport avec l'aspect optique du vitrage. Cependant, d'autres composants électroniques peuvent aussi être insérés afin de réaliser des circuits électroniques complets. Suivant le type de composants et les conducteurs électriques utilisés, ces circuits peuvent être visibles ou non.

L'insertion de diodes électroluminescentes (LED) dans les vitrages automobiles permet, notamment, les fonctionnalités de signalisation suivantes :
- affichage de témoins lumineux de signalisation destinés au chauffeur du véhicule ou aux passagers (exemple : témoin d'alarme de température du moteur dans le pare-brise, témoin de mise en fonctionnement du système de dégivrage électrique des vitres).
- affichage de témoins lumineux de signalisation destinés aux personnes à l'extérieur du véhicule (exemple : témoin de mise en fonctionnement de l'alarme du véhicule dans les vitres latérales).
- affichage lumineux sur les vitrages des véhicules (exemple : affichage lumineux clignotant sur les véhicules de secours, affichage de sécurité avec faible consommation électrique signalant la présence d'un véhicule en danger)

L'insertion de diodes électroluminescentes (LED) dans les vitrages automobiles permet, notamment, les fonctionnalités d'éclairage suivantes :
- éclairage d'ambiance de l'intérieur du véhicule de façon particulièrement esthétique (exemple : intégration de l'éclairage d'ambiance dans le toit en verre d'un véhicule).
- feux lumineux et phare dans la surface du vitrage (exemple : intégration dans la lunette arrière du véhicule du 3^{ème} feu « stop »).

L'insertion de diodes électroluminescentes infrarouge (LED) dans les vitrages automobiles permet également des fonctionnalités de communication et d'éclairage, notamment :
- émetteur infrarouge pour communication (exemple : télécommande de porte de garage, émetteur pour télépéage) ;
- éclairage de type infrarouge de la route (exemple : source lumineuse dans le pare-brise pour capteur d'aide à la conduite de nuit) ;
- détecteur de pluie ou de brouillard (exemple : capteur de pluie et/ou de brouillard inséré dans le vitrage du véhicule et destiné au contrôle automatique des essuies glaces et des phares anti-brouillard).

De plus, l'insertion de photo-diodes et de photo-résistances dans les vitrages automobiles permet, notamment, les fonctionnalités de détection suivantes :
- mesure de la luminosité ambiante (exemple : capteur de lumière pour allumage automatique des phares ou pour ajustement de la luminosité de l'éclairage interne du véhicule) ;
- détecteur pour communication infrarouge (exemple : récepteur pour télépéage routier) ;
- capteurs de température.

L'insertion de capteur de vision de type CCD ou CMOS actifs dans le visible ou l'infrarouge dans les vitrages automobiles permettent les fonctionnalités de détection et d'aide à la conduite, notamment :
- aide à la conduite (exemple : caméra CCD ou CMOS intégrée dans la vitre arrière du véhicule),
- aide à la conduite de nuit (exemple : caméra infrarouge dans le pare brise avec éclairage infrarouge associé).

De façon générale, l'invention concerne tous types de circuits électroniques insérés dans les verres feuilletés, notamment les circuits de mise en forme et d'amplification des signaux issus des antennes électromagnétiques intégrées dans ces mêmes vitrages ainsi que les circuits de contrôle des éclairages et des capteurs ci-dessus détaillés.

Un vitrage feuilleté comporte habituellement deux feuilles de verre clair ou coloré entre lesquelles sont insérées une ou plusieurs feuilles thermoplastiques de type PVB (polyvinylbutyral). Les feuilles de PVB disponibles sur le marché ont habituellement une épaisseur de 0.38 mm ou une épaisseur d'un multiple de 0.38 mm. Plus la résistance souhaitée du feuilleté est élevée, plus l'épaisseur totale de la (ou des) feuille(s) de type PVB doit être importante.

Il a été découvert qu'il est possible d'insérer tout type de composants électroniques entre deux feuilles de verre, malgré leur épaisseur non négligeable. Il existe par exemple des LED dont l'épaisseur est de 0.6 ou 0.8 mm. Dans ce cas, l'utilisation de 2 ou 3 feuilles de PVB permet l'insertion de ce type de composant électronique entre deux feuilles de verre. Il a été découvert que le traitement thermique sous pression élevée, nécessaire pour réaliser un vitrage feuilleté, n'entrave pas le bon fonctionnement des composants électroniques, ni de leurs connexions électriques.

La présente invention a pour objet un vitrage feuilleté comportant au moins deux feuilles de verre et un ou plusieurs intercalaires thermoplastiques, de type PVB, dans lequel des composants électroniques ainsi que leur circuit de connexion sont insérés entre les deux feuilles de verre, le circuit de connexion étant réalisé au moins d'une couche conductrice.

Suivant les applications recherchées, on utilisera au choix, des feuilles de verre clair, coloré, maté, sablé, sérigraphié ou tout autre type de feuille de verre approprié.

En particulier, les composants électroniques peuvent être des composants optoélectroniques, tels que des diodes électroluminescentes (LED).

De manière avantageuse, les composants électroniques insérés dans le vitrage selon l'invention ont une épaisseur inférieure ou égale à 3 mm et en particulier une épaisseur comprise entre 0.1 et 1.2 mm.

Selon un mode préféré de réalisation, les connexions électriques entre les composants et la source d'électricité sont réalisées au moyen de couches conductrices qui peuvent être transparentes ou non, et sont déposées soit sur la surface intérieure d'une ou des deux feuilles de verre, soit sur le film de PVB intercalé entre les deux feuilles de verre.

Les couches conductrices typiques sont par exemple des couches à base d'oxyde dopé dont l'épaisseur est généralement comprise entre 0.02 et 1 *µ,* de préférence entre 0.02 et 0.5 *µ*, de manière encore préférée entre 0.2 et 0.4 *µ* et dont la résistance de surface peut varier entre 5 et 80 Ω/carré, de manière préférée entre 10 et 80 Ω/carré, de manière encore préférée entre 12 et 20 Ω/carré. De telles couches comprennent par exemple de l'oxyde de zinc dopé à Indium ou à l'Aluminium, de l'oxyde d'étain dopé au fluor ou de l'oxyde d'indium dopé à l'étain (généralement connu sous l'abréviation ITO).

D'autres couches conductrices typiques sont des couches à base d'argent. Ces couches conductrices peuvent être composées d'une, deux, voire trois couches d'argent (ou tout autre matériau conducteur), séparées par des couches de diélectrique. Pour des couches comprenant une épaisseur totale de matériau conducteur comprise entre 10 et 30 nm, la résistance de surface peut atteindre des valeurs très faibles comprises entre 2 et 3 Ω/carré.

Cependant, toute autre couche même plus faiblement conductrice pourrait convenir pour réaliser les connexions électriques entre les composants électroniques. La tension à appliquer devra cependant être augmentée si la résistance de la couche est plus importante.

Selon ce mode de réalisation, la couche conductrice déposée sur le verre est avantageusement divisée en deux zones distinctes, constituant deux pistes conductrices, chacune des deux zones étant reliée à une électrode. Les composants électroniques peuvent alors être disposés en parallèles, l'une de leur borne étant en connexion avec la première zone et l'autre borne de chaque composant étant en connexion avec la deuxième zone de la couche conductrice.

La couche conductrice peut également être divisée en de nombreuses zones, chaque zone reliant un composant électronique au suivant, les composants peuvent ainsi connectés en série. Des dispositions mixtes, série et parallèle, peuvent aussi être prévues.

Il est ainsi possible de réaliser des pistes conductrices alimentant les LED en déposant une couche conductrice à propriétés anti-solaire et/ou thermiquement isolante sur la majeure partie du vitrage et en éliminant ou modifiant ensuite la couche conductrice sur de fines bandes, par exemple par laser. Pour déposer la couche conductrice, l'une ou l'autre des techniques connues peut être utilisées, par exemple la pulvérisation cathodique sous vide ou le dépôt pyrolytique en phase vapeur.

Il est également envisageable de réaliser, en une seule étape, le dépôt de la couche conductrice et des pistes conductrices par l'utilisation de masques appropriés, éventuellement réalisé par sérigraphie.

Les fines bandes sans couche ont une largeur comprise entre 0.01 et 3 mm, de préférence comprise entre 0.05 et 1.5 mm, et de manière encore préférée entre 0.1 et 0.8 mm. De cette manière, on peut obtenir des connexions électriques quasiment invisibles même si la couche conductrice présente une légère coloration.

Les LED sont généralement constituées d'une puce semi-conductrice, d'éléments de connexion électrique et d'une enveloppe dont les fonctions sont multiples (protection de l'oxydation et de l'humidité, dissipation de la chaleur, support mécanique).

Cette enveloppe peut présenter des dimensions suffisamment petites pour être insérée dans un vitrage feuilleté. Au vu du faible flux lumineux fourni par les LED actuelles, il serait nécessaire d'en disposer un grand nombre pour obtenir un éclairage intérieur automobile satisfaisant, et de réaliser un grand nombre de connexions électriques, ce qui rendrait le procédé de fabrication onéreux.

Il est possible de disposer de LED dont le flux lumineux est plus important mais, dans ce cas, l'intensité lumineuse de chaque LED est très important, ce qui génère alors des problèmes de surchauffe et/ou d'éblouissement.

Selon un mode de réalisation avantageux de l'invention, plusieurs puces sont disposées dans une enveloppe commune dont les dimensions sont telles que sa largeur et/ou sa longueur sont au moins 10 fois plus grandes que son épaisseur, de préférence 20 fois plus grande et de manière encore préférée 40 fois plus grande.

Cette enveloppe est de préférence réalisée dans une matière transparente ou esthétiquement compatible avec le vitrage utilisé. Il est également de préférence réalisé dans une matière suffisamment souple pour lui permettre d'épouser les courbures du vitrage. Il peut avantageusement comprendre une surface diffusante qui permet de lisser la lumière émise par les différentes puces.

En particulier, l'enveloppe comporte de 5 à 100 puces, de manière préférée de 10 à 50 puces, et de manière encore préférée de 15 à 40 puces.

Cette enveloppe permet de réaliser un éclairage fournissant de 10 à 500 lumens, de manière préférée de 20 à 250 lumens et de manière encore préférée de 30 à 100 lumens de manière économique, c'est-à-dire sans devoir procéder au collage d'un grand nombre de LED et sans devoir réaliser un grand nombre de connexions électriques.

De manière préférée, l'enveloppe présente une longueur et/ou une largueur comprise entre 5 et 100 mm, de préférence entre 10 et 75 mm et de manière encore préférée entre 20 et 50 mm.

L'épaisseur de l'enveloppe est de préférence inférieure ou égale à 3 mm, de manière préférée inférieure à 2 mm, inférieure à 1.2 mm, inférieure à 1 mm et de manière encore plus préférée comprise entre 0.1 et 0.7 mm.

Une telle enveloppe permet de ne réaliser que 2 contacts électriques verre/ enveloppe si la luminosité fournie par l'ensemble des puces atteint environ 50 lumens.

Selon un mode particulier de réalisation de l'invention, le vitrage comporte un interrupteur de type capacitif, actionnant l'alimentation de l'élément lumineux. Cet interrupteur est constitué d'une zone de la couche conductrice, isolée du reste de la couche conductrice, et fonctionnant comme la sonde d'un circuit capacitif.

Ceci permet de réaliser un interrupteur quasiment invisible, qui fonctionne par simple contact du doigt sur la zone isolée et qui peut être disposé à proximité de l'élément lumineux sans rompre l'esthétique du vitrage.

Selon un mode préféré de réalisation de l'invention, le vitrage est un vitrage feuilleté qui comporte deux feuilles de verre accolées à l'aide d'un ou de plusieurs intercalaires thermoplastiques (généralement de type polyvinylbutyral (PVB)), les LED et leur circuit de connexion étant insérées entre les deux feuilles de verre.

Dans ce mode de réalisation, les couches peuvent être déposées soit sur la surface intérieure d'une ou de l'autre feuille de verre, soit sur le film de PVB intercalé entre les deux feuilles de verre.

Les LED et en particulier leur enveloppe ou « package » devront résister aux conditions de température et de pression de l'étape d'autoclavage nécessaire pour la fabrication de feuilletés (de l'ordre de 10 à 15 bars et 80 à 150°C pendant 1 à 4 heures).

Lors qu'il est inséré dans un feuilleté, l'enveloppe ne doit pas nécessairement répondre aux exigences de protection contre l'humidité et l'oxydation qui sont généralement exigées pour les enveloppes des LED classiques et pour une utilisation sur un verre simple.

L'homme du métier pourra prévoir tout type de disposition des connexions électriques pour connecter les LED ou les puces à l'intérieur de l'enveloppe, au choix, en série, en parallèle ou prévoir une disposition mixte qui a l'avantage de fournir une luminosité homogène.

La présente invention est illustrée par les exemples de réalisation spécifique ci-dessous, ces exemples n'étant pas limitatifs, et référence étant faite aux fig. dans lesquelles,
les fig. 1 à 4 représentent, en coupe, un vitrage feuilleté comportant un élément lumineux réalisé avec une ou plusieurs LED traditionnelles ;
les fig. 5 et 6 représentent un vitrage feuilleté comportant un élément lumineux réalisé avec des LED particulières;
La fig. 7 représente une vue d'ensemble d'un pare-brise comportant, dans sa partie supérieure, un élément lumineux ainsi qu'une zone pour l'allumage et l'extinction de l'élément lumineux.

La présente invention est illustrée par les exemples de réalisation spécifique ci-dessous, ces exemples n'étant pas limitatifs, et référence étant faite aux fig. dans lesquelles,

### Exemple 1 :

Les éléments suivants ont été empilés :
- une feuille de verre vert de 3.6 mm d'épaisseur comportant une couche conductrice à base d'oxyde d'étain dopé au fluor, de 300 nm d'épaisseur et d'environ 15 Ω/□, la couche conductrice ayant été éliminée sur une fine bande de manière à délimiter deux zones conductrices distinctes;
- 2 feuilles de PVB clair totalisant une épaisseur de 0.76 mm;
- un nombre suffisant de LED pour obtenir l'effet lumineux recherché, collées sur ladite zone sans couche conductrice, les extrémités anode de chaque diode étant en contact avec une des deux zones de la couche conductrice et les côtés cathode de chaque diode étant en contact avec l'autre zone de la couche conductrice ; chacune des deux zones étant elles-mêmes connectées à une électrode ;
- 1 feuille de PVB clair d'une épaisseur de 0.38 mm,
- une feuille de verre clair de 2.1 mm d'épaisseur.

L'ensemble est passé à l'autoclave pendant un cycle de 120 min qui comporte au minimum 35 min à température et pression élevées (125°C et 8 bars).

Dans ce mode de réalisation, les LED sont disposées en parallèle. Ce mode de réalisation a l'avantage de fournir un circuit de connexion totalement invisible même en utilisant deux feuilles de verre clair.

### Exemple 2 :

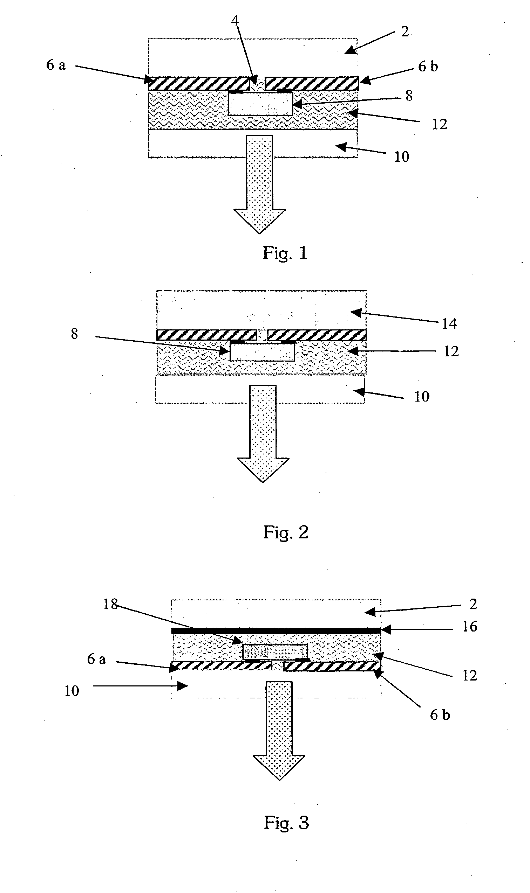

La fig. 1 représente un vitrage feuilleté réalisé comme suit. Une couche conductrice 6 (conductivité d'environ 2 Ω/carré) a été déposée sur une feuille 2 de verre sodo-calcique clair de 2.1 mm d'épaisseur, destinée à être la feuille de verre extérieure du vitrage. La couche conductrice 6 est éliminée au laser sur de fines bandes 4 d'environ 0.15 mm de large, de manière à délimiter des pistes conductrices 6a, 6b. Des LED 8 dont les dimensions extérieures ne dépassent pas 0.6 mm d'épaisseur sont collées de part et d'autre d'une fine bande 4 avec une colle conductrice. Des colles conductrices typiques sont par exemple des colles à l'argent.

La feuille de verre 2 est alors laminée, face revêtue vers l'intérieur, avec une deuxième feuille 10 de verre sodo-calcique clair de manière traditionnelle, en intercalant une feuille thermoplastique double 12 de 0.72 mm d'épaisseur totale.

Pour l'exemple illustré, la colle doit être choisie pour sa résistance aux hautes températures et pression nécessaire pour réaliser le vitrage feuilleté. Elle doit aussi être choisie en fonction de sa viscosité de manière à éviter qu'elle ne se répande dans la bande isolante 4 lors du laminage du feuilleté.

Le flux lumineux émis par la LED est indiqué par la flèche. Il est orienté vers la feuille de verre intérieure 10 du vitrage.

### Exemple 3:

La fig. 2 représente un vitrage feuilleté, similaire à celui de l'exemple 1, mis à part que la feuille de verre extérieure est une feuille de verre coloré 14. Ce type de verre feuilleté est particulièrement bien approprié pour réaliser un toit automobile. Sa transmission lumineuse (TL) peut ainsi être abaissée à 14% et sa transmission énergétique (TE) à 11%.

### Exemple 4 :

La Fig. 3 représente un vitrage feuilleté comportant une feuille de verre extérieure 2 constituée de verre clair sodo-calcique. Une couche de décoration opaque 16 est déposée sur une partie de la surface intérieure de la feuille de verre 2. La couche conductrice 6 est, dans ce cas, déposée sur la feuille de verre intérieure 10, sur sa face tournée vers intérieur du vitrage feuilleté. Des pistes conductrices 6a, 6b sont réalisées, comme aux exemples précédents, par l'élimination de la couche sur de fines bandes 4. Des LED 18, de type « reverse », c'est-à-dire prévues pour être collées par leur côté émettant la lumière, sont collées de part et d'autre des bandes 4, sur la feuille de verre intérieure 10 du vitrage.

Ce mode de réalisation permet de rendre le dispositif lumineux invisible du côté extérieur du vitrage puisque les LED 18 sont situées derrière la couche opaque 16 du vitrage.

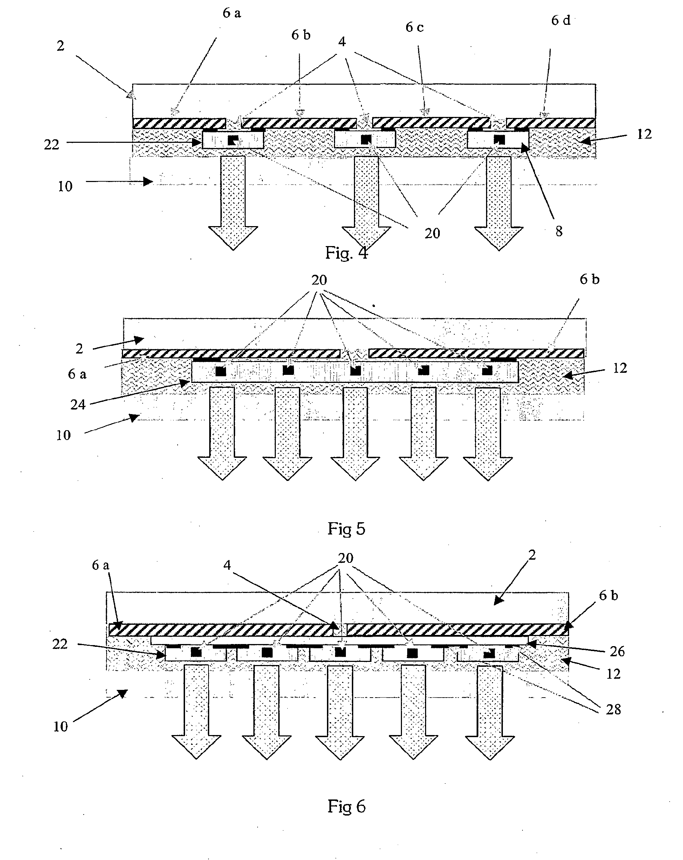

La fig. 4 représente le même mode de réalisation qu'à la fig. 2. Les LED 8 sont représentées avec une puce semi-conductrice 20 chacune encapsulée dans une enveloppe 22. Des pistes conductrices distinctes 6a, ...6d sont nécessaires pour relier chaque LED 8.

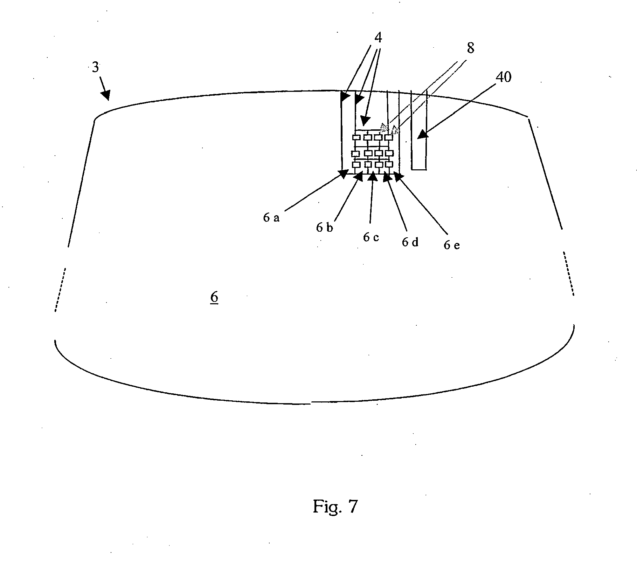

La fig. 7 représente une vue d'ensemble d'un pare-brise 34 comportant un élément lumineux constitué, dans le cas illustré schématiquement, de douze LED 8. Des pistes conductrices 6 a, 6 b, ... 6 e, délimitées par des bandes 4 où la couche 6 a été éliminée, relient chacune des LED 8 en série. Dans le cas illustré, 3 séries de 4 LED 8 sont connectées en parallèle.

La fig. 7 montre également une zone conductrice 40 délimitée par des bandes isolantes 4. Celle- ci fonctionne comme une touche capacitive et permet l'allumage et l'extinction de l'élément lumineux.

### Exemple 5 :

Le vitrage représenté à la fig. 5 comporte comme à l'exemple 1 : une feuille de verre extérieure 2 revêtu d'une couche conductrice 6, un intercalaire thermoplastique 12, et une feuille de verre intérieure 10. L'élément lumineux est réalisé par l'utilisation d'une LED particulièrement adaptée pour cet usage et qui comporte une pluralité de puces semi-conductrices 20 dans une seule enveloppe 24. Ce mode de réalisation nécessite de réaliser moins de pistes conductrices, voir uniquement 2 pistes conductrices 6a, 6b si l'intensité lumineuse fournie par les puces semi-conductrices 20 encapsulées dans une seule enveloppe 24 est suffisante pour l'application recherchée. Ce mode de réalisation permet également de réaliser des bandes 4, entre les pistes conductrices 6a, 6b, plus larges et évite les risques de fluage de la colle dans les bandes isolantes.

### Exemple 6 :

Le vitrage représenté à la fig. 6 comporte comme aux exemples 1 et 4 : une feuille de verre extérieure 2 revêtu d'une couche conductrice 6, un intercalaire thermoplastique 12, et une feuille de verre intérieure 10. L'élément lumineux est réalisé par l'utilisation d'un film souple 26, par exemple en PET, sur lequel sont collées un ensemble de LED 8 constituées de leur enveloppe 22 encapsulant chacune une ou éventuellement plusieurs puces semi-conductrices 20. Une connexion électrique 28 est prévue sur le film 26, entre chaque enveloppe 22 et entre la dernière enveloppe et la couche conductrice (non représenté). Comme à l'exemple précédent, ce mode de réalisation permet de réaliser peu de pistes conductrices 6a, 6b et de réaliser des bandes 4 relativement larges, ce qui évite le fluage de la colle dans la bande 4. Le vitrage est réalisé en collant en une seule fois un ensemble de LED 8 pré-disposées sur le film 26.

Selon l'invention, il est donc possible d'obtenir un vitrage tout à fait homogène qui comporte en son sein un dessin lumineux. Les LED ont l'avantage de ne consommer que très peu d'énergie et de ne dissiper pratiquement aucune chaleur. Grâce à leur petite taille, lorsque le dispositif est éteint, les LED ne sont pratiquement pas visibles. Il est donc envisageable de disposer des composants électroniques, non seulement au pourtour du vitrage mais également sur la partie centrale ou sur une grande partie de la surface vitrée sans pour autant entraver la visibilité si le circuit de connexion est réalisé grâce des couches conductrices.

Les LED sont généralement monochromatiques et sont disponibles dans toutes les teintes. L'intensité lumineuse d'une LED varie généralement entre 10 et 180 mCd. En insérant un grand nombre de LED, une intensité lumineuse équivalente à celle d'un éclairage incandescent peut être obtenue, tout en ne nécessitant qu'une consommation bien plus faible.

Bien entendu, l'invention ne se limite pas à ce type de réalisation ni à ce type de fonction, tous autres composants électroniques standards du marché, par exemple ceux conçus pour les cartes électroniques peuvent être insérés, selon l'invention entre deux feuilles de verre, pour autant que leur miniaturisation soit suffisante.

Les composants pour montage en surface de type SMD (Surface Mount Device) sont particulièrement bien adaptés. Ces composants peuvent être insérés dans le vitrage dans leur packaging habituel prévu pour le montage en surface des cartes électroniques ou dans un packaging spécialement adapté à l'insertion dans le vitrage ou même sans packaging, le vitrage constituant lui-même dans ce cas le packaging.

## Revendications

1. Vitrage feuilleté comportant deux feuilles de verre (2,10,14) et un ou plusieurs intercalaires thermoplastiques (12), des LED (8, 18) étant insérées entre les deux feuilles de verre, un circuit de connexion étant réalisé au moyen d'une couche conductrice (6) déposée sur la surface intérieure d'une ou des deux feuilles de verre ladite couche (6) étant divisée en au moins deux zones distinctes, chacune des deux zones étant reliées à une électrode, **caractérisé en ce que** des zones (6a, 6b, 6 e) ont été isolées du reste de la couche par de fines bandes isolantes (4), les bandes isolantes (4) ayant une largeur comprise entre 0.01 et 3 mm, de préférence entre 0.05 et 1.5 mm, et de manière encore préférée entre 0.1 et 0.8 mm.

2. Vitrage selon la revendication 1, **caractérisé en ce que** la couche conductrice (6) a une épaisseur comprise entre 0.02 et 0.5 *µ,* de préférence comprise entre 0.2 et 0.4 *µ*.

3. Vitrage selon l'une quelconque des revendications 1 et 2, **caractérisé en ce que** la couche (6) présente une résistance comprise entre 2 et 80 Ω/carré, de préférence entre 10 et 80 et de manière encore préférée entre 12 et 20 Ω/carré.

4. Vitrage selon l'une quelconque des revendications précédentes, **caractérisé en ce que** les composants électroniques (8, 18) ont une épaisseur inférieure ou égale à 3 mm et en particulier une épaisseur comprise entre 0.1 et 1.2 mm.

5. Vitrage selon l'une quelconque des revendications précédentes, **caractérisé en ce que** les LED comportent plusieurs puces semi-conductrices (2) dans une enveloppe (24).

6. Vitrage selon la revendication précédente, **caractérisé en ce que** l'enveloppe (24) présente des dimensions telles que sa longueur et /ou une largeur sont au moins 10 fois plus grandes que son épaisseur, de préférence 20 fois plus grande et de manière encore préférée 40 fois plus grande.

7. Vitrage selon l'une quelconque des revendications 5 et 6, **caractérisé en ce que** l'enveloppe (24) présente une longueur et/ou une largeur comprise entre 5 et 100 mm, de préférence entre 15 et 75 mm et de manière encore préférée entre 25 et 50 mm.

8. Vitrage selon l'une quelconque des revendications précédentes, **caractérisé en ce qu'**un interrupteur (40) actionnant l'alimentation du composant électronique (8, 18) est constitué d'une zone de la couche conductrice (6) isolée du reste de la couche conductrice par de fines bandes (4).

## Patentansprüche

1. Verbundverglasung, umfassend zwei Glasfolien (2, 10, 14) und eine oder mehrere thermoplastische Zwischenlagen (12), wobei LEDs (8, 18) zwischen den beiden Glasfolien eingesetzt sind, wobei eine Anschlussschaltung mit Hilfe einer leitenden Schicht (6), die auf die Innenfläche einer oder beider Glasfolien aufgebracht ist, hergestellt ist, wobei die Schicht (6) in mindestens zwei getrennte Zonen geteilt ist, wobei jede der beiden Zonen mit einer Elektrode verbunden ist, **dadurch gekennzeichnet, dass** Zonen (6a, 6b, ... 6e) von der übrigen Schicht durch dünne Isolierbänder (4) isoliert wurden, wobei die Isolierbänder (4) eine Breite zwischen 0,01 und 3 mm, vorzugsweise zwischen 0,05 und 1,5 mm und auf noch bevorzugtere Weise zwischen 0,1 und 0,8 mm haben.

2. Verglasung nach Anspruch 1, **dadurch gekennzeichnet, dass** die leitende Schicht (6) eine Dicke zwischen 0,02 und 0,5 µ, vorzugsweise zwischen 0,2 und 0,4 µ hat.

3. Verglasung nach einem der Ansprüche 1 und 2, **dadurch gekennzeichnet, dass** die Schicht (6) einen Widerstand zwischen 2 und 80 Ω/Quadrat, vorzugsweise zwischen 10 und 80 und auf noch bevorzugtere Weise zwischen 12 und 20 Ω/Quadrat hat.

4. Verglasung nach einem der vorhergehenden Ansprüche, **dadurch gekennzeichnet, dass** die Elektronikkomponenten (8, 18) eine Dicke kleiner oder gleich 3 mm und insbesondere eine Dicke zwischen 0,1 und 1,2 mm haben.

5. Verglasung nach einem der vorhergehenden Ansprüche, **dadurch gekennzeichnet, dass** die LEDs mehrere Halbleiterchips (2) in einer Hülle (24) umfassen.

6. Verglasung nach dem vorhergehenden Anspruch, **dadurch gekennzeichnet, dass** die Hülle (24) derartige Abmessungen aufweist, dass ihre Länge und/oder eine Breite mindestens 10-mal größer als ihre Dicke sind, vorzugsweise 20-mal größer und auf noch bevorzugtere Weise 40-mal größer.

7. Verglasung nach einem der Ansprüche 5 und 6, **dadurch gekennzeichnet, dass** die Hülle (24) eine Länge und/oder eine Breite aufweist, die zwischen 5 und 100 mm, vorzugsweise zwischen 15 und 75 mm und auf noch bevorzugtere Weise zwischen 25 und 50 mm beträgt.

8. Verglasung nach einem der vorhergehenden Ansprüche, **dadurch gekennzeichnet, dass** ein Schalter (40), der die Versorgung der Elektronikkomponente (8, 18) betätigt, von einer Zone der leitenden Schicht (6), die von der restlichen leitenden Schicht durch dünne Bänder (4) isoliert ist, gebildet ist.

## Claims

1. Laminated glazing unit comprising two glass sheets (2, 10, 14) and one or more thermoplastic interlayers (12), LEDs (8, 18) being inserted between the two glass sheets, a connecting circuit being formed by means of a conductive layer (6) deposited on the interior surface of one of the two glass sheets, said layer (6) being divided into at least two separate zones, each of the two zones being connected to an electrode, **characterized in that** zones (6a, 6b... 6e) have been insulated from the rest of the layer by thin insulating strips (4), the insulating strips (4) having a width comprised between 0.01 and 3 mm, preferably between 0.05 and 1.5 mm and even more preferably between 0.1 and 0.8 mm.

2. Glazing unit according to Claim 1, **characterized in that** the conductive layer (6) has a thickness comprised between 0.02 and 0.5 µ and preferably comprised between 0.2 and 0.4 µ.

3. Glazing unit according to either one of Claims 1 and 2, **characterized in that** the layer (6) has a resistance comprised between 2 and 80 Ω/square, preferably between 10 and 80 and even more preferably between 12 and 20 Ω/square.

4. Glazing unit according to any one of the preceding claims, **characterized in that** the electronic components (8, 18) have a thickness smaller than or equal to 3 mm and in particular a thickness comprised between 0.1 and 1.2 mm.

5. Glazing unit according to any one of the preceding claims, **characterized in that** the LEDs comprise a plurality of semiconductor chips (2) in an envelope (24).

6. Glazing unit according to the preceding claim, **characterized in that** the envelope (24) has dimensions such that its length and/or a width are at least 10 times larger than its thickness, preferably 20 times larger and even more preferably 40 times larger.

7. Glazing unit according to either one of Claims 5 and 6, **characterized in that** the envelope (24) has a length and/or a width comprised between 5 and 100 mm, preferably between 15 and 75 mm and even more preferably between 25 and 50 mm.

8. Glazing unit according to any one of the preceding claims, **characterized in that** a switch (40) actuating the power supply of the electronic component (8, 18) is made up of a zone of the conductive layer (6) that is insulated from the rest of the conductive layer by thin strips (4).
